# EUROPEAN PATENT APPLICATION

(11) **EP 4 848 261 A1**
(43) Date of publication of application: **02.12.2026**
(21) Application number: 25900157.6
(22) Date of filing: 11.11.2025
(51) Int. Cl.: G09F 9/33

(54) **FAULT-IDENTIFIABLE DISPLAY SCREEN MECHANISM**

(30) Priority: 06.12.2024 CN 202423012736 U
(71) Applicant: Shenzhen Gloshine Technology Co., Ltd., Shenzhen, Guangdong Province 518000 (CN)
(72) Inventor: ZHANG, Xianfeng, Shenzhen, Guangdong 518000 (CN); LI, Guoqiang, Shenzhen, Guangdong 518000 (CN); GUO, Yongfeng, Shenzhen, Guangdong 518000 (CN); CHEN, Xinyong, Shenzhen, Guangdong 518000 (CN)
(74) Representative: Herrero & Asociados, S.L.
(86) International application number: PCT/CN2025/133974
(87) International publication number: WO 2026/118805

(57) **Abstract**

A display screen mechanism capable of fault identification, including a frame (1) and a display assembly (2) mounted on the frame (1). The display assembly (2) includes a first identification member (21), a module end cap (22), and a display light board mounted on the module end cap (22), and the module end cap (22) is provided with a first internal space and a first opening (221). The first identification member (21) includes a first identification plate (211) and a first toggle block (212) connected to the first identification plate (211), and the first identification plate (211) is provided with a first identification portion (2111) and a second identification portion (2112) located on opposite sides of the first toggle block (212). The first identification plate (211) is slidably mounted in the first internal space, the first toggle block (212) extends from the first opening (221), and the first identification portion (2111) or the second identification portion (2112) is located in the first opening (221). The first identification portion (2111) and the second identification portion (2112) can identify whether the display assembly (2) is in a normal or faulty state, and by toggling the first toggle block (212), the first identification portion (2111) or the second identification portion (2112) can be displayed, making the operation simple.

## Description

This application claims priority to Chinese Patent Application No. 202423012736.9, titled "Display Screen Mechanism Capable of Fault Identification", filed with the China National Intellectual Property Administration on December 6, 2024, the entire content of which is incorporated herein by reference.

### TECHNICAL FIELD

The present application relates to the technical field of display screens, and in particular, to a display screen mechanism capable of fault identification.

### BACKGROUND

LED (Light Emitting Diode) display screens are widely used in various fields. Generally, a display screen includes a frame and a plurality of display light boards mounted within the frame, where the display light boards are configured to display images, and the frame serves to support the display screen. During use, the display light boards may be damaged, and the damaged display light boards need to be disassembled from the frame for repair. Typically, without proper identification or special marking on the damaged modules, they are easily confused when stored together with new modules, thereby bringing certain inconvenience to repair and maintenance.

### SUMMARY

To address the technical problem in the prior art where new and old display light boards are easily confused, the present application provides a display screen mechanism capable of fault identification.

In view of the above technical problem, embodiments of the present application provide a display screen mechanism capable of fault identification, including:
a frame; and
a display assembly mounted on the frame;
the display assembly includes a first identification member, a module end cap, and a display light board mounted on the module end cap, the module end cap being provided with a first internal space and a first opening communicating with the first internal space;
the first identification member includes a first identification plate and a first toggle block connected to the first identification plate, the first identification plate being provided with a first identification portion and a second identification portion located on opposite sides of the first toggle block; and
the first identification plate is slidably mounted in the first internal space, the first toggle block extends from the first opening, and the first identification portion or the second identification portion is located in the first opening.

Optionally, the module end cap includes a first rear cover and a first cover plate mounted on the first rear cover, the display light board being mounted on the first rear cover; the first internal space is disposed between the first rear cover and the first cover plate, and the first opening is disposed at an end of the first rear cover facing away from the display light board.

Optionally, the display screen mechanism capable of fault identification further includes a power supply assembly; the power supply assembly includes a second identification member, a power supply end cap provided with an accommodating space, and a power supply body mounted in the accommodating space; the power supply end cap is detachably mounted on the frame, and the second identification member is mounted on the power supply end cap and configured to identify whether the power supply assembly is damaged.

Optionally, the power supply end cap is provided with a second internal space and a second opening communicating with the second internal space;
the second identification member includes a second identification plate and a second toggle block connected to the second identification plate, the second identification plate being provided with a third identification portion and a fourth identification portion located on opposite sides of the second toggle block; and
the second identification plate is slidably mounted in the second internal space, the second toggle block extends from the second opening, and the third identification portion or the fourth identification portion is located in the second opening.

Optionally, the power supply end cap includes a box body and a second cover plate, the accommodating space being disposed on the box body, and the box body being detachably mounted on the frame; and
the second cover plate is mounted on the box body and located in the accommodating space, the second internal space is disposed between the box body and the second cover plate, and the second opening is disposed on the second cover plate.

Optionally, the power supply assembly further includes a power supply locking member mounted on the power supply end cap, the power supply locking member being provided with a latching portion; and
the frame is provided with a locking slot, and the power supply end cap is mounted on the frame through the latching portion being locked in the locking slot.

Optionally, the display assembly further includes a module handle mounted on an end of the module end cap facing away from the display light board.

Optionally, the display screen mechanism capable of fault identification further includes an assembling locking member mounted on the frame; an end of the frame facing away from the assembling locking member is provided with a locking hole; and
the assembling locking member on one of the frames is locked in the locking hole on another of the frames for splicing two adjacent frames.

Optionally, an end of the frame facing away from the locking hole is provided with a through hole;
the assembling locking member includes an elastic member, a locking rod, and a handle mounted on the locking rod, an end of the locking rod away from the handle being provided with a locking portion matching the locking hole, and the locking rod being rotatably mounted in the through hole; and
the elastic member is sleeved on the locking rod, and opposite ends of the elastic member abut against the handle and the frame, respectively.

Optionally, the frame is provided with a plurality of mounting slots distributed at intervals; and
the display screen mechanism capable of fault identification includes a plurality of the display assemblies, and the display assemblies are mounted in the mounting slots in a one-to-one correspondence.

In the present application, the first sliding plate of the first identification member is slidably mounted in the first internal space of the module end cap, and the first toggle block of the first identification member extends from the first opening. Maintenance personnel can drive the first identification plate to slide in the first internal space through the first toggle block. When the first identification portion is located at the first opening, the second identification portion is hidden in the first internal space, and the maintenance personnel can see the first identification portion through the first opening. When the second identification portion is located at the first opening, the first identification portion is hidden in the first internal space, and the maintenance personnel can see the second identification portion through the first opening. The first identification portion and the second identification portion can identify whether the display assembly is in a normal or faulty state. By toggling the first toggle block, the first identification portion or the second identification portion can be displayed. Therefore, the identification operation of the display screen mechanism capable of fault identification is simplified, preventing maintenance personnel from confusing old display assemblies with new ones and facilitating maintenance of the display assemblies.

### BRIEF DESCRIPTION OF THE DRAWINGS

The present application is further described below with reference to the accompanying drawings and embodiments.
FIG. 1 is a structural schematic view of a display screen mechanism capable of fault identification according to an embodiment of the present application;
FIG. 2 is a partial enlarged view of area A in FIG. 1;
FIG. 3 is a structural schematic view of a first identification member of the display screen mechanism capable of fault identification according to an embodiment of the present application;
FIG. 4 is a structural schematic view of a module end cap of the display screen mechanism capable of fault identification according to an embodiment of the present application;
FIG. 5 is a structural schematic view of a power supply assembly of the display screen mechanism capable of fault identification according to an embodiment of the present application;
FIG. 6 is a partial enlarged view of area B in FIG. 5.

Reference numerals in the specification are as follows:
1. Frame; 11. Locking hole; 12. Mounting slot; 2. Display assembly; 21. First identification member; 211. First identification plate; 2111. First identification portion; 2112. Second identification portion; 212. First toggle block; 22. Module end cap; 221. First opening; 222. First rear cover; 223. First cover plate; 224. Module handle; 3. Power supply assembly; 31. Second identification member; 311. Second identification plate; 312. Second toggle block; 32. Power supply end cap; 321. Second opening; 322. Box body; 323. Second cover plate; 324. Accommodating space; 4. Power supply locking member; 41. Latching portion; 5. Assembling locking member; 51. Elastic member; 52. Locking rod; 53. Handle.

### DETAILED DESCRIPTION OF EMBODIMENTS

To make the technical problems, technical solutions, and beneficial effects to be achieved by the present application clearer, the present application is further described in detail below with reference to the accompanying drawings and embodiments. It should be understood that the embodiments described herein are merely intended to illustrate the present application and are not intended to limit the scope of the present application.

It should be understood that the orientation or positional relationships indicated by the terms "upper," "lower," "left," "right," "front," "back," "middle," etc. are based on the orientation or positional relationships shown in the drawings. These terms are only used for the convenience of describing the present application and simplifying the description, rather than indicating or implying that the device or element referred to must have a particular orientation, or be constructed and operated in a particular orientation, and therefore cannot be understood as a limitation of the present application.

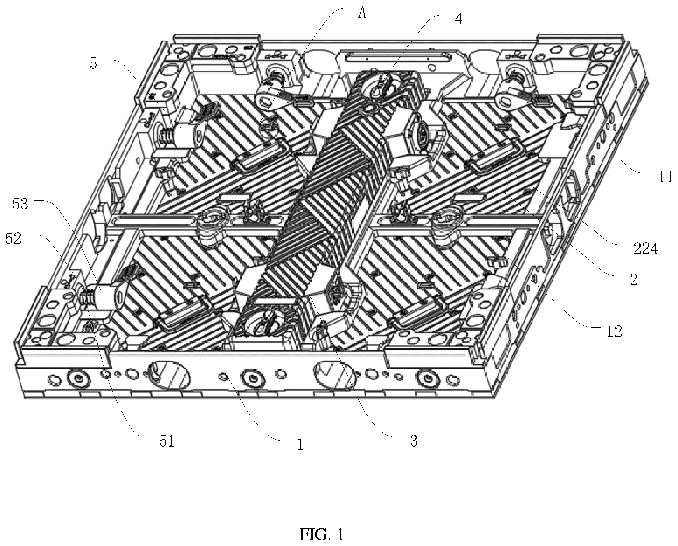

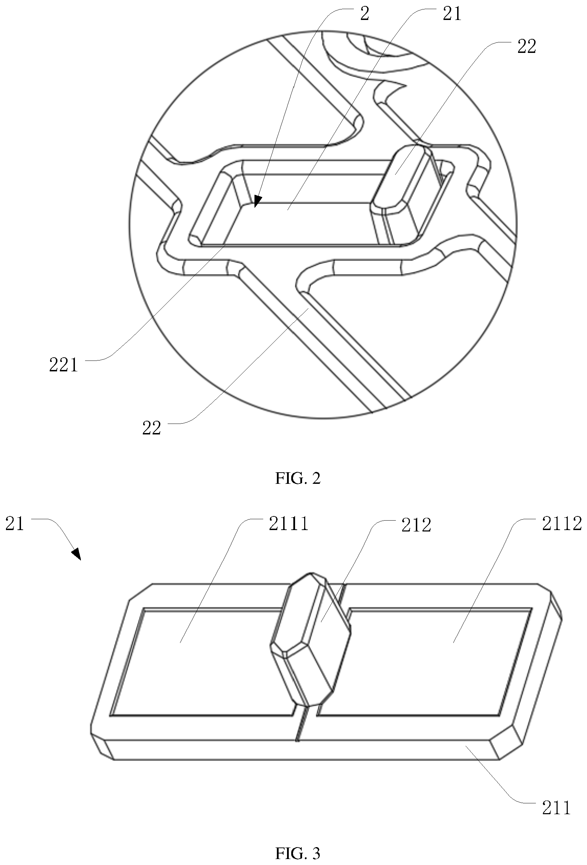

As shown in FIGS. 1 to 3, an embodiment of the present application provides a display screen mechanism capable of fault identification, including a frame 1 and a display assembly 2 mounted on the frame 1. The display assembly 2 includes a first identification member 21, a module end cap 22, and a display light board (not shown in the figures) mounted on the module end cap 22. The module end cap 22 is provided with a first internal space (not shown in the figures) and a first opening 221 communicating with the first internal space. Understandably, the first opening 221 is disposed at an end of the module end cap 22 facing away from the display light board. The display light board includes, but is not limited to, an LED module or the like.

The first identification member 21 includes a first identification plate 211 and a first toggle block 212 connected to the first identification plate 211. The first identification plate 211 is provided with a first identification portion 2111 and a second identification portion 2112 located on opposite sides of the first toggle block 212. Understandably, the first toggle block 212 and the first identification plate 211 are an integrally formed part. The first identification portion 2111 and the second identification portion 2112 can identify the state of the display assembly 2 through different extensions, text, patterns, or the like.

The first identification plate 211 is slidably mounted in the first internal space, the first toggle block 212 extends from the first opening 221, and the first identification portion 2111 or the second identification portion 2112 is located in the first opening 221.

In the present application, the first sliding plate of the first identification member 21 is slidably mounted in the first internal space of the module end cap 22, and the first toggle block 212 of the first identification member 21 extends from the first opening 221. Maintenance personnel can drive the first identification plate 211 to slide in the first internal space through the first toggle block 212. When the first identification portion 2111 is located at the first opening 221, the second identification portion 2112 is hidden in the first internal space, and the maintenance personnel can see the first identification portion 2111 through the first opening 221. When the second identification portion 2112 is located at the first opening 221, the first identification portion 2111 is hidden in the first internal space, and the maintenance personnel can see the second identification portion 2112 through the first opening 221. The first identification portion 2111 and the second identification portion 2112 can identify whether the display assembly 2 is in a normal or faulty state. By toggling the first toggle block 212, the first identification portion 2111 or the second identification portion 2112 can be displayed. Therefore, the identification operation of the display screen mechanism capable of fault identification is simplified, preventing maintenance personnel from confusing old display assemblies 2 with new ones and facilitating maintenance of the display.

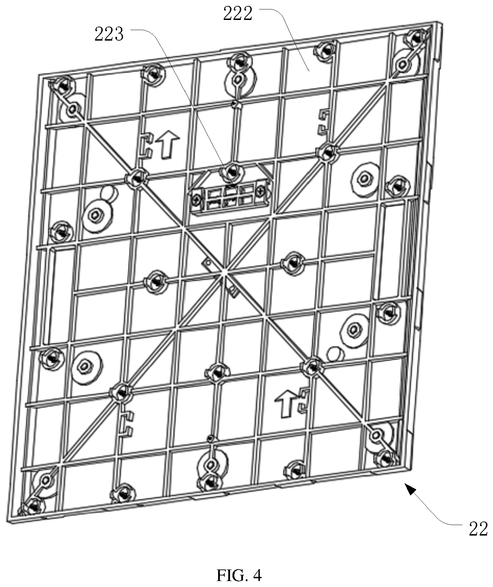

In an embodiment, as shown in FIG. 4, the module end cap 22 includes a first rear cover 222 and a first cover plate 223 mounted on the first rear cover 222, and the display light board is mounted on the first rear cover 222. The first internal space is disposed between the first rear cover 222 and the first cover plate 223, and the first opening 221 is disposed at an end of the first rear cover 222 facing away from the display light board. Understandably, the first cover plate 223 is mounted on an inner surface of the first rear cover 222, and the first cover plate 223 can be fixedly mounted on the first rear cover 222 by screws, bolts, or the like. In this embodiment, the first opening 221 is disposed on the first rear cover 222, so that the first identification portion 2111 or the second identification portion 2112 displayed through the first opening 221 can be seen from the rear of the frame 1. Therefore, the first identification member 21 can identify whether the display assembly 2 on the frame 1 is damaged.

In an embodiment, as shown in FIGS. 1, 5, and 6, the display screen mechanism capable of fault identification further includes a power supply assembly 3. The power supply assembly 3 includes a second identification member 31, a power supply end cap 32 provided with an accommodating space 324, and a power supply body (not shown in the figures) mounted in the accommodating space 324. The power supply end cap 32 is detachably mounted on the frame 1, and the second identification member 31 is mounted on the power supply end cap 32 and configured to identify whether the power supply assembly 3 is damaged. Understandably, the second identification member 31 can be the same as or different from the first identification member 21, and the power supply assembly 3 can supply power to components such as the display light board. In this embodiment, the second identification member 31 can identify whether the power supply assembly 3 is damaged, which facilitates the maintenance of the power supply assembly 3 by maintenance personnel.

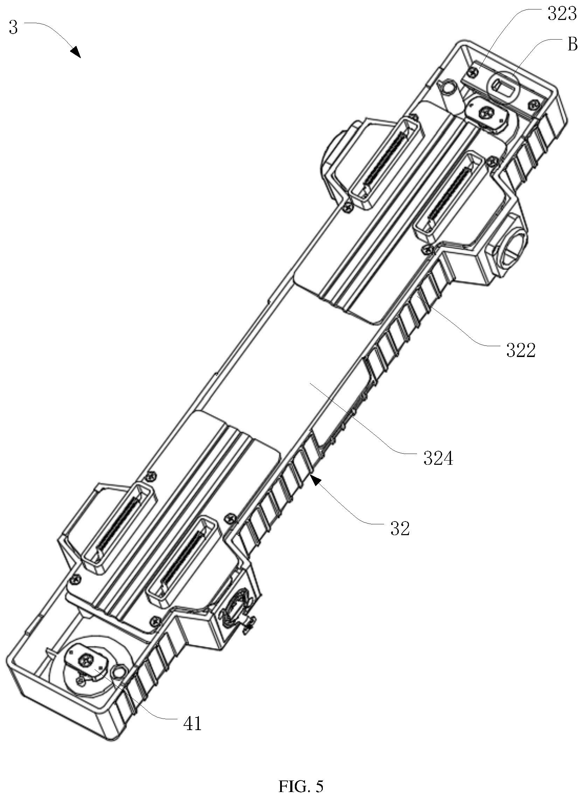

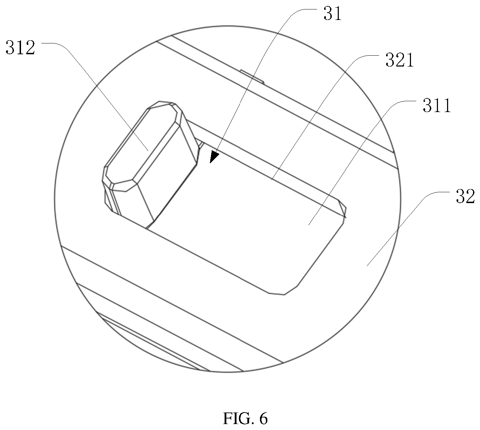

In an embodiment, as shown in FIG. 5 and FIG. 6, the power supply end cap 32 is provided with a second internal space and a second opening 321 communicating with the second internal space. The second identification member 31 includes a second identification plate 311 and a second toggle block 312 connected to the second identification plate 311. The second identification plate 311 is provided with a third identification portion and a fourth identification portion located on opposite sides of the second toggle block 312. The second toggle block 312 and the second identification plate 311 are an integrally formed part. The third identification portion and the fourth identification portion can identify the state of the power supply assembly 3 through different extensions, text, patterns, or the like.

The second identification plate 311 is slidably mounted in the second internal space, the second toggle block 312 extends from the second opening 321, and the third identification portion or the fourth identification portion is located in the second opening 321.

Specifically, maintenance personnel can drive the second identification plate 311 to slide in the second internal space through the second toggle block 312. When the third identification portion is located at the second opening 321, the fourth identification portion is hidden in the second internal space, and the maintenance personnel can see the through the second opening 321. When the fourth identification portion is located at the second opening 321, the third identification portion is hidden in the second internal space, and the maintenance personnel can see the fourth identification portion through the second opening 321. The third identification portion and the fourth identification portion can identify whether the power supply assembly 3 is in a normal or faulty state. By toggling the second toggle block 312, the third identification portion or the fourth identification portion can be displayed, thereby facilitating the maintenance of the power supply assembly 3 by maintenance personnel.

In an embodiment, as shown in FIG. 5, the power supply end cap 32 includes a box body 322 and a second cover plate 323. The accommodating space 324 is disposed on the box body 322, and the box body 322 is detachably mounted on the frame 1. Understandably, the box body 322 can be detachably mounted on the frame 1 using a locking assembly, a buckle assembly, or the like.

The second cover plate 323 is mounted on the box body 322 and located in the accommodating space 324. The second internal space is disposed between the box body 322 and the second cover plate 323, and the second opening 321 is disposed on the second cover plate 323. In this embodiment, the second opening 321 faces the frame 1. After disassembling the box body 322 from the frame 1, the second toggle block 312 can be toggled, so that the second identification member can identify the normal or faulty state of the power supply assembly 3.

In an embodiment, as shown in FIG. 1 and FIG. 5, the power supply assembly 3 further includes a power supply locking member 4 mounted on the power supply end cap 32. The power supply locking member 4 is provided with a latching portion 41. The frame 1 is provided with a locking slot (not shown in the figures), and the power supply end cap 32 is mounted on the frame 1 through the latching portion 41 being locked in the locking slot. In this embodiment, by rotating the power supply locking member 4, the latching portion 41 is locked in the locking slot or disengaged from the locking slot. When the latching portion 41 is locked in the locking slot, the power supply end cap 32 is locked on the frame 1. When the latching portion 41 is disengaged from the locking slot, the power supply end cap 32 can be disassembled from the frame 1. In this embodiment, the design of the power supply locking member 4 facilitates the disassembly and assembly of the power supply end cap 32 and the frame 1.

In an embodiment, as shown in FIG. 1, the display assembly 2 further includes a module handle 224 mounted on an end of the module end cap 22 facing away from the display light board. Understandably, a user can carry the display assembly 2 through the module handle 224, thereby facilitating the transport of the display assembly 2.

In an embodiment, as shown in FIG. 1, the display screen mechanism capable of fault identification further includes an assembling locking member 5 mounted on the frame 1. An end of the frame 1 facing away from the assembling locking member 5 is provided with a locking hole 11. Understandably, when the assembling locking member 5 is mounted on the left side of the frame 1, the locking hole 11 is disposed on the right side of the frame 1; and when the assembling locking member 5 is mounted on the front side of the frame 1, the locking hole 11 is disposed on the back side of the frame 1.

The assembling locking member 5 on one frame 1 is locked in the locking hole 11 on another frame 1 for splicing two adjacent frames 1 (that is, when two adjacent display screen mechanisms capable of fault identification are assembled, the assembling locking member 5 on one frame 1 is locked in the locking hole 11 on another frame 1). In this embodiment, the design of the assembling locking member 5 facilitates the assembly of multiple display screen mechanisms capable of fault identification.

In an embodiment, as shown in FIG. 1, an end of the frame 1 facing away from the locking hole 11 is provided with a through hole. The assembling locking member 5 includes an elastic member 51, a locking rod 52, and a handle 53 mounted on the locking rod 52. An end of the locking rod 52 away from the handle 53 is provided with a locking portion (not shown in the figures) matching the locking hole 11, and the locking rod 52 is rotatably mounted in the through hole. The elastic member 51 is sleeved on the locking rod 52, and opposite ends of the elastic member 51 abut against the handle 53 and the frame 1, respectively. Understandably, the elastic member 51 includes, but is not limited to, a spring or the like. The locking portion can extend from the through hole or retract into the through hole. The locking rod 52 can be rotatably mounted in the through hole through a threaded structure.

Specifically, the locking rod 52 is rotated through the handle 53 to cause the locking portion to extend from the through hole or retract into the through hole. When two adjacent frames 1 are assembled, the locking portion retracts into the through hole. After sides of the two adjacent frames 1 abut against each other, the locking portion extends from the through hole and is locked in the locking hole 11, thereby completing the assembly of the two adjacent frames 1.

In an embodiment, as shown in FIG. 1, the frame 1 is provided with a plurality of mounting slots 12 distributed at intervals. The display screen mechanism capable of fault identification includes a plurality of the display assemblies 2, and the display assemblies 2 are mounted in the mounting slots 12 in a one-to-one correspondence. Understandably, the design of the plurality of display assemblies 2 improves the applicability and versatility of the display screen mechanism capable of fault identification.

The above are only embodiments of the display screen mechanism capable of fault identification of the present application and are not intended to limit the present application. Any modifications, equivalent substitutions, and improvements made within the spirit and principles of the present application shall fall within the protection scope of the present application.

## Claims

1. A display screen mechanism capable of fault identification, comprising:
a frame; and
a display assembly mounted on the frame;
wherein the display assembly comprises a first identification member, a module end cap, and a display light board mounted on the module end cap, the module end cap being provided with a first internal space and a first opening communicating with the first internal space;
the first identification member comprises a first identification plate and a first toggle block connected to the first identification plate, the first identification plate being provided with a first identification portion and a second identification portion located on opposite sides of the first toggle block; and
the first identification plate is slidably mounted in the first internal space, the first toggle block extends from the first opening, and the first identification portion or the second identification portion is located in the first opening.

2. The display screen mechanism capable of fault identification of claim 1, wherein the module end cap comprises a first rear cover and a first cover plate mounted on the first rear cover, the display light board being mounted on the first rear cover; the first internal space is disposed between the first rear cover and the first cover plate, and the first opening is disposed at an end of the first rear cover facing away from the display light board.

3. The display screen mechanism capable of fault identification of claim 1, further comprising a power supply assembly, wherein the power supply assembly comprises a second identification member, a power supply end cap provided with an accommodating space, and a power supply body mounted in the accommodating space; the power supply end cap is detachably mounted on the frame, and the second identification member is mounted on the power supply end cap and configured to identify whether the power supply assembly is damaged.

4. The display screen mechanism capable of fault identification of claim 3, wherein the power supply end cap is provided with a second internal space and a second opening communicating with the second internal space;
the second identification member comprises a second identification plate and a second toggle block connected to the second identification plate, the second identification plate being provided with a third identification portion and a fourth identification portion located on opposite sides of the second toggle block; and
the second identification plate is slidably mounted in the second internal space, the second toggle block extends from the second opening, and the third identification portion or the fourth identification portion is located in the second opening.

5. The display screen mechanism capable of fault identification of claim 4, wherein the power supply end cap comprises a box body and a second cover plate, the accommodating space being disposed on the box body, and the box body being detachably mounted on the frame; and
the second cover plate is mounted on the box body and located in the accommodating space, the second internal space is disposed between the box body and the second cover plate, and the second opening is disposed on the second cover plate.

6. The display screen mechanism capable of fault identification of claim 3, wherein the power supply assembly further comprises a power supply locking member mounted on the power supply end cap, the power supply locking member being provided with a latching portion; and
the frame is provided with a locking slot, and the power supply end cap is mounted on the frame through the latching portion being locked in the locking slot.

7. The display screen mechanism capable of fault identification of claim 1, wherein the display assembly further comprises a module handle mounted on an end of the module end cap facing away from the display light board.

8. The display screen mechanism capable of fault identification of claim 1, further comprising an assembling locking member mounted on the frame, wherein an end of the frame facing away from the assembling locking member is provided with a locking hole; and
the assembling locking member on one of the frames is locked in the locking hole on another of the frames for splicing two adjacent frames.

9. The display screen mechanism capable of fault identification of claim 8, wherein an end of the frame facing away from the locking hole is provided with a through hole;
the assembling locking member comprises an elastic member, a locking rod, and a handle mounted on the locking rod, an end of the locking rod away from the handle being provided with a locking portion matching the locking hole, and the locking rod being rotatably mounted in the through hole; and
the elastic member is sleeved on the locking rod, and opposite ends of the elastic member abut against the handle and the frame, respectively.

10. The display screen mechanism capable of fault identification of any one of claims 1 to 9, wherein the frame is provided with a plurality of mounting slots distributed at intervals; and
the display screen mechanism capable of fault identification comprises a plurality of the display assemblies, and the display assemblies are mounted in the mounting slots in a one-to-one correspondence.
